# EUROPEAN PATENT APPLICATION

(11) **EP 1 331 094 A1**
(43) Date of publication of application: **30.07.2003**
(21) Application number: 01980976.3
(22) Date of filing: 02.11.2001
(51) Int. Cl.: B41F 15/40

(54) **SQUEEZE UNIT AND CREAM SOLDER PRINTER**

(30) Priority: 02.11.2000 JP 2000335856; 13.04.2001 JP 2001115004; 26.04.2001 JP 2001129039
(71) Applicant: THE FURUKAWA ELECTRIC CO., LTD., Tokyo 100-8322 (JP)
(72) Inventor: HIKAMI, Toshiya, THE FURUKAWA ELECTRIC CO., LTD., Tokyo 100-8322 (JP); NAKAMURA, Yoshinori, THE FURUKAWA ELECTRIC CO, LTD, Tokyo 100-8322 (JP)
(74) Representative: Stein-Dräger, Christiane
(86) International application number: JP0109645
(87) International publication number: WO02036345

(57) **Abstract**

A squeegee unit comprises a paste pressurizing slope (7a) and a squeegee (9). The paste pressurizing slope (7a) is inclined at an angle narrower than 90° to a surface (3b) of a screen mask (3) in a printing direction (X). As solder paste (8) is pressurized by means of the paste pressurizing slope (7a), the solder paste (8) is filled into a mask hole (3a). The squeegee (9) has a paste scraping surface (9a) for scraping off the solder paste (8) on the screen mask (3). The paste scraping surface (9a) extends at an angle (θ1) of 90° or more to the surface (3b) of the screen mask (3) in the printing direction (X).

## Description

### Technical Field

The present invention relates to a squeegee unit for printing solder paste for soldering electronic components on a substrate and a solder-paste printing machine using the same.

### Background Art

In mounting electronic components, such as a chip capacitor, chip resistor, ball-grid array (BGA), chip-scale package (CSP), etc., on a substrate, solder paste is printed on a land portion of the substrate, on which the electrodes of these electronic components are placed, by means of a solder-paste printing machine.

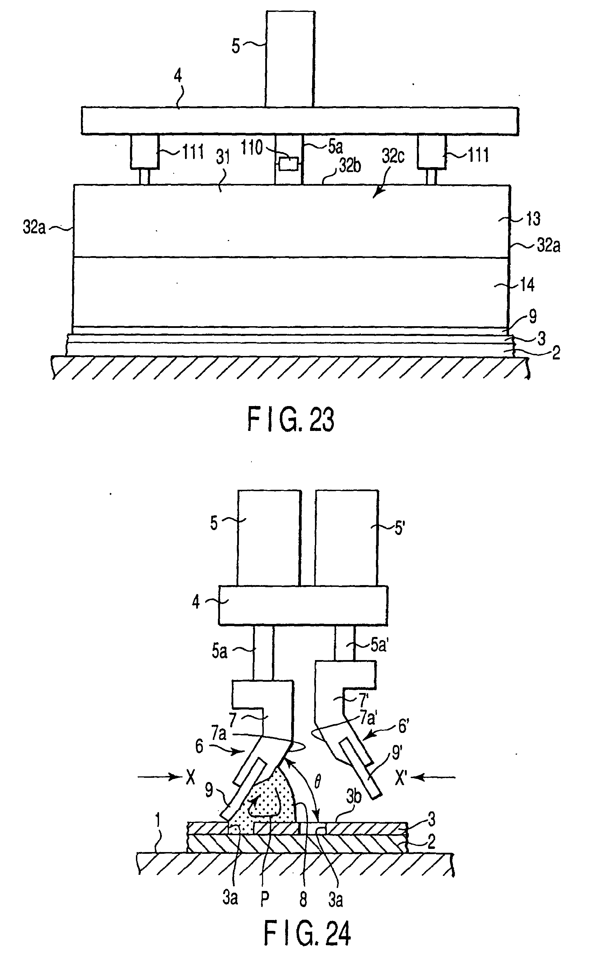

FIG. 24 shows a conventional solder-paste printing machine. This solder-paste printing machine comprises a printing table 1 that ascends and descends. A substrate 2 is located on the table 1. A screen mask 3 is fixed over the substrate 2. An air cylinder 5 is supported upright on a support member 4 that is situated over the screen mask 3. A piston rod 5a of the air cylinder 5 penetrates the support member 4 so as to be slidable in the vertical direction. A squeegee unit 6 is supported on the lower end of the piston rod 5a.

The squeegee unit 6 comprises a squeegee holder member 7 attached to the lower end of the piston rod 5a and a squeegee 9 supported on the squeegee holder member 7. The squeegee 9 scrapes off solder paste 8 on the screen mask 3. The squeegee holder member 7 has a paste pressurizing slope 7a. The paste pressurizing slope 7a extends at an angle θ narrower than 90° to a surface 3b of the screen mask 3 in a printing direction X. The squeegee 9 that is supported on the squeegee holder member 7 is inclined substantially at the same angle θ as the paste pressurizing slope 7a.

The air cylinder 5 and the squeegee unit 6 constitute a forward-stroke printing unit for printing the solder paste 8 in the X-direction. An air cylinder 5' and a squeegee unit 6' constitute a backward-stroke printing unit for printing the solder paste 8 in an X'-direction. This backward-stroke printing unit and the forward-stroke printing unit are located symmetrically with respect to an axis perpendicular to the substrate 2.

In carrying out X-direction printing by means of the solder-paste printing machine constructed in this manner, the printing table 1 is raised to bring the substrate 2 on the table 1 into contact with the lower surface of the screen mask 3. In this state, the squeegee 9 is rested on the screen mask 3 by means of the air cylinder 5. Then, the squeegee 9 is run in the X-direction to pressurize the solder paste 8 on the screen mask 3 by means of the paste pressurizing slope 7a. The solder paste 8 pressurized by means of a surface that contains the paste pressurizing slope 7a, squeegee 9, and screen mask 3 is filled into a mask hole 3a of the screen mask 3. The solder paste 8 on the screen mask 3 is scraped off by means of the squeegee 9. Thereafter, the printing table 1 is lowered together with the substrate 2, whereupon the substrate 2 leaves the screen mask 3. In this manner, the solder paste 8 is printed in a predetermined position on the substrate 2.

In the conventional solder-paste printing machine described above, the solder paste 8 rolls as indicated by arrow P in FIG. 24 as the squeegee 9 moves in the printing direction on the screen mask 3. Therefore, the force to lift the squeegee 9 acts on the squeegee 9. In order to scrape off the solder paste 8 cleanly to prevent it remaining on the surface 3b of the screen mask 3, the squeegee 9 must be subjected to a printing pressure that is high enough to resist the force to lift the squeegee 9. The force to lift the squeegee 9 changes depending on the speed of the squeegee 9, the viscosity of the solder paste 8, and the quantity of the solder paste 8. If the speed of the squeegee 9 is changed, or if the type of solder paste 8 or the quantity of solder paste 8 fed onto the screen mask 3 is changed, test printing is needed to determine the printing pressure that meets the condition.

The aforesaid printing pressure is expected to be set at a low value within the range that causes no failed scraping. If an excessive printing pressure is applied to the squeegee 9, the distal end of the squeegee 9 gets into the mask hole 3a of the screen mask 3, thereby inevitably scooping out the solder paste 8 in the mask hole 3a, in the case where the material of the squeegee 9 is an elastic material such as urethane rubber. There is also a problem that an excessive printing pressure causes the squeegee 9 to bend without regard to the material of the squeegee 9, so that the angle θ of the squeegee 9 to the screen mask 3 changes. The narrower the angle θ, the higher the printing pressure is. In some cases, therefore, the solder paste 8 may ooze out from the mask hole 3a to the backside of the mask 3. If the printing pressure is low, in contrast with this, the squeegee 9 lifts above the surface of the screen mask 3, so that the solder paste 8 suffers failed scraping. Thus, the angle θ of the squeegee 9 considerably influences the printing pressure, and the printability varies inevitably depending on the printing pressure.

If the squeegee 9 is urged against the screen mask 3 by position control, not by load control, indentations, if any, on the surface of the substrate 2 arouse the following problem. If there are projections on the surface of the substrate 2, an excessive pressure is produced, inevitably causing the solder paste 8 in the mask hole 3a to be scooped out. If there are recesses in the surface of the substrate 2, the printing pressure may be too low meaning that the solder paste 8 suffers failed scraping.

### Disclosure of Invention

An object of the present invention is to provide a squeegee unit and a solder-paste printing machine, capable of preventing force that lifts a squeegee as solder paste rolls.

Another object of the present invention is to provide a squeegee unit and a solder-paste printing machine, designed so that the capability of a squeegee to scrape off solder paste is not affected by changes in the squeegee speed, solder paste viscosity, or quantity of the solder paste.

Another object of the present invention is to provide a squeegee unit and a solder-paste printing machine, capable of following waviness of a substrate or a screen mask.

Another object of the present invention is to provide a squeegee unit and a solder-paste printing machine, capable of fully transmitting pressure produced on a paste pressurizing slope to a mask hole.

Another object of the present invention is to provide a squeegee unit and a solder-paste printing machine, designed so that a wide high-pressure area can be provided for solder paste that is pressurized by means of a paste pressurizing slope, and that the efficiency of paste packing into a mask hole can be improved even in high-speed printing operation.

Another object of the present invention is to provide a squeegee unit and a solder-paste printing machine, which can be designed so that a unit having a squeegee can be held as required lest it descend.

Another object of the present invention is to provide a squeegee unit and a solder-paste printing machine, capable of obviating the necessity of test printing under altered printing conditions.

Another object of the present invention is to provide a squeegee unit and a solder-paste printing machine, capable of adjusting the pressure of solder paste without influencing the capability of a squeegee to scrape off the solder paste.

Another object of the present invention is to provide a solder-paste printing machine, designed so that a squeegee can be securely brought into contact with a screen mask.

The squeegee unit of the present invention is designed so that a paste scraping surface of a squeegee extends at an angle of 90° or more to a surface of a screen mask in a printing direction. According to this invention, the squeegee cannot be lifted by means of the pressure of solder paste between a paste pressurizing slope and the surface of the screen mask if the pressure rises during printing operation.

Preferably, in the squeegee unit of this invention, the surface that contains the paste pressurizing slope, squeegee, and screen mask forms a solder paste enclosure. According to this configuration, the solder paste pressurized in the solder paste enclosure is pressed against the screen mask, so that the efficiency of packing of the solder paste into a mask hole is improved.

In the squeegee unit of the present invention, a near distal end portion of the squeegee in contact with the screen mask may be elastic. According to this configuration, the distal end portion of the squeegee can follow waviness of a substrate or the screen mask, so that the solder paste can be scraped off satisfactorily.

In the squeegee unit of the present invention, the paste pressurizing slope may project from the paste scraping surface of the squeegee in the printing direction. According to this configuration, pressure produced near the paste pressurizing slope as the solder paste rolls can be fully applied to the surface of the screen mask.

In the squeegee unit of the present invention, the squeegee holder for supporting the squeegee may be provided with a paste pressurizing slope and formed having a surface that adjoins the paste pressurizing slope and extends along the surface of the screen mask. According to this configuration, a wide high-pressure area can be provided for the solder paste that is pressurized by means of the paste pressurizing slope, and the efficiency of paste packing into the mask hole can be improved even in a high-speed printing operation.

The squeegee unit of the present invention may comprise a paste pressurizing unit having the paste pressurizing slope and a scraping unit having the squeegee, the paste pressurizing unit and the scraping unit being independently movable toward and away from the screen mask without a gap. According to this configuration, the pressure of the pressurized solder paste can be maintained, and the capability of the squeegee to scrape off the solder paste cannot be affected if the printing speed, the viscosity of the solder paste, or the quantity of the solder paste changes. Further, the printing pressure for the solder paste can be adjusted by moving the paste pressurizing slope up and down with the squeegee kept in a predetermined position on the screen mask.

The squeegee unit of the present invention may comprise a squeegee descent preventing mechanism for preventing the scraping unit from descending with respect to the paste pressurizing unit. According to this configuration, the squeegee descent preventing mechanism can lock the scraping unit to prevent it descending as the substrate leaves the screen mask after a printing operation is finished, for example. Thus, the substrate can separate uniformly from the screen mask.

A solder-paste printing machine comprises a screen mask having a mask hole, a member having a paste pressurizing slope extending at an angle of 90° or less to a surface of the screen mask in a printing direction, a squeegee movable in a printing direction along the screen mask, the squeegee having a paste scraping surface for scraping off the solder paste on the screen mask, and a drive mechanism for moving the member having the paste pressurizing slope and the squeegee in the printing direction, the paste scraping surface extending at an angle of 90° or more to the surface of the screen mask in the printing direction.

According to this invention, the squeegee cannot be lifted by means of the pressure of the solder paste between the paste pressurizing slope and the surface of the screen mask if the pressure rises.

The solder-paste printing machine of this invention may comprise an urging member for bringing the scraping unit into contact with the surface of the screen mask. According to this configuration, printing can be carried out with the squeegee securely in contact with the screen mask.

In the solder-paste printing machine of this invention, a seal member may be provided between the paste pressurizing unit and the scraping unit. According to this configuration, the solder paste in a pressurized state can be prevented from leaking out through a gap between the paste pressurizing unit and scraping unit, so that the pressure of the solder paste can be prevented from lowering.

In the solder-paste printing machine of this invention, the paste pressurizing unit may comprise a space setting mechanism for adjusting the distance from a surface substantially parallel to the surface of the screen mask to the screen mask. According to this configuration, the printing pressure for printing the solder paste can be easily set by means of the space setting mechanism.

The paste pressurizing unit may comprise an automatic squeegee unit lift mechanism for raising and lowering the support member. According to this configuration, the paste pressurizing unit can be automatically raised and lowered by means of the automatic squeegee unit lift mechanism, so that the pressure of the solder paste can be adjusted automatically.

In the solder-paste printing machine of this invention, the paste pressurizing unit may comprise a pressure sensor for detecting the pressure of the solder paste on the screen mask.

A squeegee unit of the present invention according to another aspect comprises a first paste pressurizing slope for pressurizing solder paste on a screen mask, thereby filling the solder paste into a mask hole, a second paste pressurizing slope reversely opposed to the first paste pressurizing slope and capable of pressurizing the solder paste on the screen mask, thereby filling the solder paste into the mask hole, a first squeegee movable in a printing direction along the screen mask, the first squeegee having a paste scraping surface for scraping off the solder paste on the screen mask, a second squeegee reversely opposed to the first squeegee and movable in the printing direction along the screen mask, the second squeegee having a paste scraping surface for scraping off the solder paste on the screen mask, and a solder paste enclosure forming a solder paste chamber enclosing the solder paste between the first and second squeegees.

According to the squeegee unit of this invention, the solder paste cannot easily come into contact with air during a printing operation, so that changes in the properties of the solder paste that are attributable to oxidation or flux evaporation can be reduced, and an appropriate push force for the solder paste can be maintained with ease. Further, forward-stroke printing and backward-stroke printing can be carried out without causing the solder paste to leak out from the solder paste chamber. Since the pressure of the solder paste can be kept at a high level during a printing operation, moreover, the efficiency of packing of the solder paste into the mask hole can be improved.

In the squeegee unit of this invention, the paste scraping surface of the first squeegee may extend at an angle of 90° or more to the surface of the screen mask in the printing direction, and the paste scraping surface of the second squeegee may also extend at an angle of 90° or more to the surface of the screen mask in the printing direction. According to this configuration, the push force that is produced as the solder paste rolls never acts on the squeegee.

In the squeegee unit of this invention, the solder paste chamber may be provided with a solder paste supply mechanism for supplying the solder paste.

In the squeegee unit of this invention, at least a part of the solder paste supply mechanism may be incorporated in a member having the paste pressurizing slope. According to this configuration, the external appearance of the squeegee unit can be simplified.

The squeegee unit of this invention may comprise a pressure sensor for detecting the pressure of the solder paste in the solder paste chamber so that the solder paste supply mechanism can supply the solder paste to the solder paste chamber in accordance with the signal from the pressure sensor. According to this configuration, the solder paste can be automatically supplied to the solder paste chamber when the quantity of the solder paste is reduced.

The squeegee unit of this invention may comprise members formed having the first and second paste pressurizing slopes, individually, and first and second slide holder members provided for vertical movement without leaving gaps with respect to the members, the first and second slide members being provided with the first and second squeegees, respectively.

### Brief Description of Drawings

FIG. 1 is a side view, partially in section, showing one embodiment of a squeegee unit according to the present invention;
FIG. 2 is a side view, partially in section, showing another embodiment of the squeegee unit according to the present invention;
FIG. 3 is a side view, partially in section, showing still another embodiment of the squeegee unit according to the present invention;
FIG. 4 is a side view, partially in section, showing still another embodiment of the squeegee unit according to the present invention;
FIG. 5A is an enlarged side view showing a part of a first comparative example of the squeegee unit;
FIG. 5B is an enlarged side view showing a part of a second comparative example of the squeegee unit;
FIG. 6A is an enlarged side view showing a part of a squeegee unit of another embodiment of the present invention;
FIG. 6B is an enlarged side view showing a part of the squeegee unit shown in FIG. 4;
FIG. 7 is a side view showing an embodiment of a solder-paste printing machine of the present invention in which squeegee units shown in FIG. 4 are opposed to each other;
FIG. 8 is a side view of a solder-paste printing machine, partially in section, showing another embodiment of the present invention;
FIG. 9 is a sectional view of a portion of the solder-paste printing machine shown in FIG. 8 to which a pressure sensor is attached;
FIG. 10 is a side view of a solder-paste printing machine showing another embodiment of the present invention;
FIG. 11 is a diagram showing relations between the respective printing speeds and necessary forces for scraping off solder paste of the solder-paste printing machine shown in FIG. 10 and a conventional solder-paste printing machine;
FIG. 12 is a side view of a part of a squeegee unit showing another embodiment of the present invention;
FIG. 13 is a side view of a solder-paste printing machine showing another embodiment of the present invention;
FIG. 14A is a front view of a part of a solder-paste printing machine showing another embodiment of the present invention;
FIG. 14B is a side view of a part of the solder-paste printing machine shown in FIG. 14A;
FIG. 15 is a side view of a part of a squeegee unit showing another embodiment of the present invention;
FIG. 16 is a side view of a part of a squeegee unit showing still another embodiment of the present invention;
FIG. 17 is a side view of a solder-paste printing machine showing another embodiment of the present invention;
FIG. 18 is a front view of a solder-paste printing machine showing still another embodiment of the present invention;
FIG. 19 is a sectional view of a portion of a solder-paste printing machine according to another embodiment of the present invention to which a sensor is attached;
FIG. 20 is a side view of a solder-paste printing machine showing another embodiment of the present invention;
FIG. 21 is a side view of a solder-paste printing machine, partially in section, showing another embodiment of the present invention;
FIG. 22 is a side view of a solder-paste printing machine, partially in section, showing still another embodiment of the present invention;
FIG. 23 is a front view of the solder-paste printing machine shown in FIG. 22;
FIG. 24 is a side view, partially in section, showing a conventional solder-paste printing machine.

### Best Mode of Carrying Out of the Invention

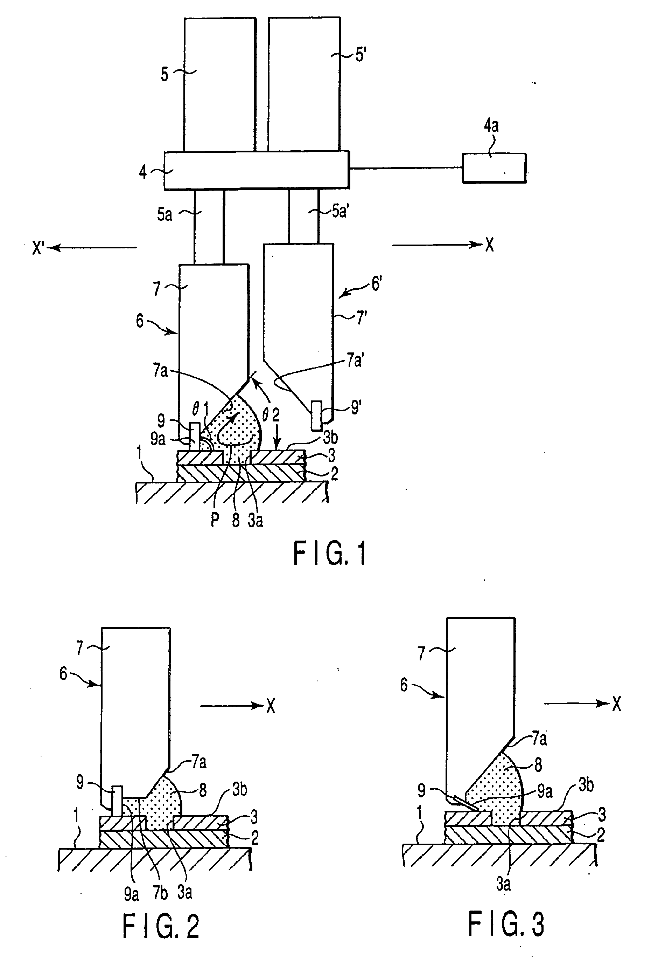

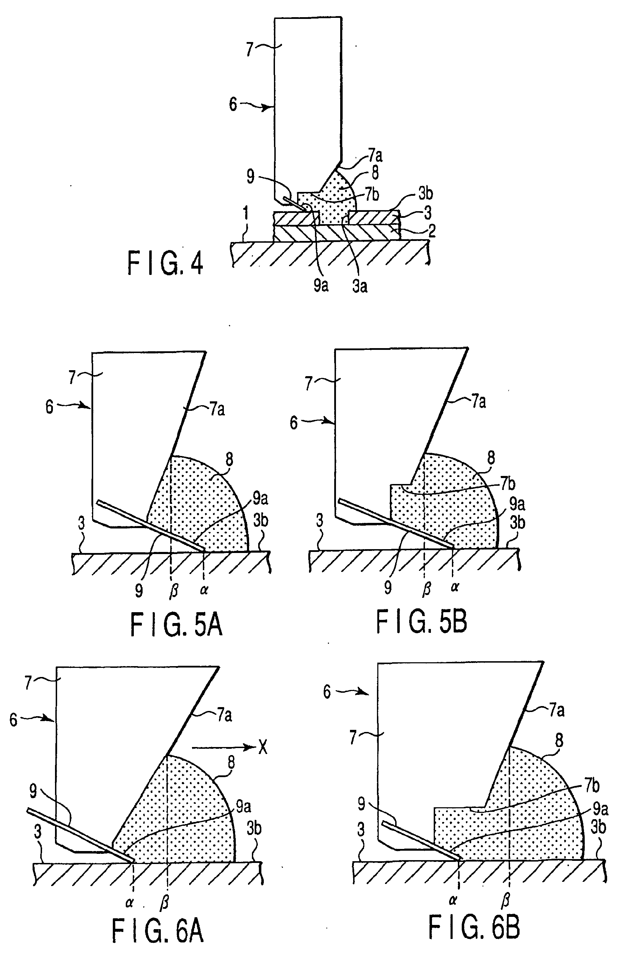

A squeegee 9 of a squeegee unit 6 shown in FIG. 1 is supported by a squeegee holder member 7. The squeegee holder member 7 is provided with a paste pressurizing slope 7a. A paste scraping surface 9a of the squeegee 9 extends at an angle θ1 of about 90° to a surface 3b of a screen mask 3 in a printing direction X. The squeegee 9 is formed of an elastic material such as urethane rubber. Therefore, the distal end portion of the squeegee 9 that touches the screen mask 3 is also elastic. The paste pressurizing slope 7a, like that of a squeegee unit 6 (mentioned later) shown in FIGS. 6A and 6B, projects beyond the paste scraping surface 9a of the squeegee 9 in the printing direction X. A squeegee unit 6' is opposed to the squeegee unit 6. The squeegee unit 6' is also provided with a squeegee holder member 7' having a paste pressurizing slope 7a', squeegee 9', etc. These squeegee units 6 and 6' are moved in printing directions X and X', respectively, by means of a drive mechanism 4a.

In the squeegee unit 6 shown in FIG. 1, the pressure of solder paste 8 that is pressurized by means of the paste pressurizing slope 7a is transmitted to the surface 3b of the screen mask 3 by means of a substantially closed curved surface that includes the paste pressurizing slope 7a, squeegee 9, and screen mask 3. Thus, the pressure of the solder paste 8 can be fully transmitted to a mask hole 3a, so that the efficiency of packing of the solder paste 8 into the mask hole 3a is improved.

The paste scraping surface 9a of the squeegee unit 6 shown in FIG. 1 extends at the angle θ1 of about 90° to the surface 3b of the screen mask 3. If the pressure of the solder paste 8 between the paste pressurizing slope 7a and the surface 3b of the screen mask 3 rises during printing operation, therefore, that pressure never causes the squeegee 9 to be lifted, so that the solder paste 8 can be prevented from suffering failed scraping.

Since the distal end portion of the squeegee 9 that touches the screen mask 3 is elastic, the distal end portion of the squeegee 9 can be caused to follow the waviness of a substrate 2 or the screen mask 3. Thus, the solder paste 8 on the screen mask 3 can be scraped off satisfactorily.

Further, the paste pressurizing slope 7a projects beyond the paste scraping surface 9a of the squeegee 9 in the printing direction X. Therefore, the pressure that is generated on the paste pressurizing slope 7a as the solder paste 8 rolls (indicated by arrow P in FIG. 1) can be fully transmitted to the mask hole 3a.

In a squeegee unit 6 of another embodiment of the present invention shown in FIG. 2, as in the embodiment of FIG. 1, a paste scraping surface 9a of a squeegee 9 extends at an angle of about 90° to the surface 3b of the screen mask 3 in the printing direction X. A squeegee holder member 7 that has a paste pressurizing slope 7a is formed having a surface 7b that adjoins the paste pressurizing slope 7a and extends substantially parallel to the surface 3b of the screen mask 3. For the configuration of other parts, the embodiment shown in FIG. 2 is similar to the embodiment of FIG. 1.

In this embodiment (FIG. 2), the squeegee holder member 7 is provided with the paste pressurizing slope 7a, and has the surface 7b that adjoins the paste pressurizing slope 7a and extends substantially parallel to the surface 3b of the screen mask 3. Therefore, a wide high-pressure area can be provided for the solder paste 8 that is pressurized by means of the paste pressurizing slope 7a, so that the efficiency of paste packing into the mask hole 3a can be improved even in a high-speed printing operation.

In another squeegee unit 6 of the present invention shown in FIG. 3, a paste scraping surface 9a of a squeegee 9 extends at an angle of 90° or more to the surface 3b of the screen mask 3 in the printing direction. The squeegee 9 is formed of a plate spring of stainless steel with a thickness of 100 µm. For the configuration of other parts, the embodiment shown in FIG. 3 is similar to the embodiment of FIG. 1. The embodiment shown in FIG. 3 can produce the same effects of the embodiment of FIG. 1.

In a squeegee unit 6 of another embodiment of the present invention shown in FIG. 4, a surface 7b substantially parallel to the surface 3b of the screen mask 3 is formed adjacent to a paste pressurizing slope 7a of a squeegee holder member 7. The embodiment shown in FIG. 4 can produce the same effects of the embodiment of FIG. 2.

In each of the comparative examples shown in FIGS. 5A and 5B, a paste pressurizing slope 7a does not project beyond a paste scraping surface 9a of a squeegee 9 in the printing direction. In each of the embodiments shown in FIGS. 6A and 6B, on the other hand, a paste pressurizing slope 7a projects beyond a paste scraping surface 9a of a squeegee 9 in the printing direction. Either of the squeegee holder members 7 shown in FIGS. 5B and 6B has a surface 7b that extends substantially parallel to the surface 3b of the screen mask 3.

In each of the squeegee holder members 7 shown in FIGS. 5A and 5B, an upper end position β of the paste pressurizing slope 7a that touches the solder paste 8 does not project beyond a distal end position α of the paste scraping surface 9a of the squeegee 9 in the printing direction. If the internal pressure of the solder paste 8 on the paste scraping surface 9a increases during a printing operation, therefore, the pressure of that part of the solder paste 8 which touches the screen mask 3 does not increase much. Although the squeegee holder members 7 shown in FIGS. 5A and 5B have a paste pressurizing slope 7a, therefore, the efficiency of packing of the solder paste 8 into the mask hole 3a is not satisfactory.

In each of the squeegee holder members 7 shown in FIGS. 6A and 6B, the upper end position β of the paste pressurizing slope 7a that touches the solder paste 8 projects beyond the distal end position α of the paste scraping surface 9a of the squeegee 9 in the printing direction. As the internal pressure of the solder paste 8 increases during a printing operation, therefore, the solder paste 8 can be fully loaded into the mask hole 3a.

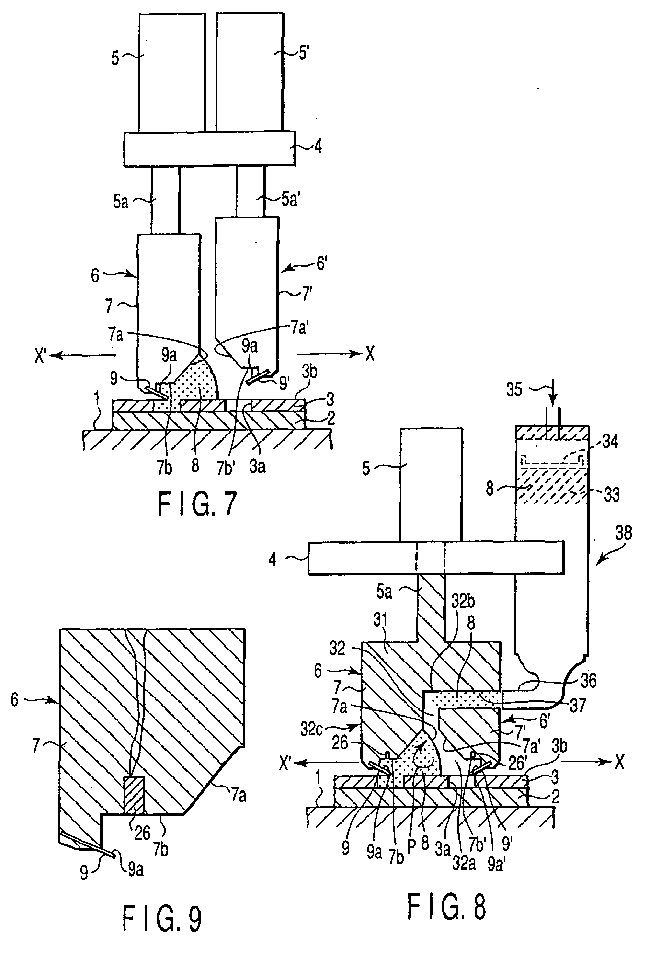

The solder-paste printing machine shown in FIG. 7 has the first squeegee unit 6 shown in FIG. 4 and a second squeegee unit 6' opposed to the squeegee unit 6. Air cylinders 5 and 5' are vertically supported on a support member 4. Piston rods 5a and 5a' of the air cylinders 5 and 5' can lower one of the squeegee units 6 and 6' and raise the other.

In this embodiment, the first squeegee unit 6 is brought into contact with the screen mask 3 by means of the elastic force of the squeegee 9 alone when printing is carried out in the X-direction. When the substrate 2 leaves the screen mask 3 after the printing operation is finished, therefore, the screen mask 3 is deformed little, so that satisfactory substrate release can be effected. When printing is carried out in the X'-direction, the first squeegee unit 6 rises, while the second squeegee unit 6' lowers, whereupon the squeegee 9' touches the screen mask 3.

In this embodiment (FIG. 7), the solder paste 8 that is also pressurized by means of the paste pressurizing slope 7a is pushed toward the screen mask 3 by means of a substantially closed curved surface that includes the paste pressurizing slope 7a, squeegee 9, and screen mask 3, so that the efficiency of packing of the solder paste 8 into the mask hole 3a can be improved.

FIG. 8 shows a solder-paste printing machine of another embodiment of the present invention. A substrate 2 is located on a printing table 1 that can ascend and descend. A screen mask 3 is fixed over the substrate 2 by means of a fixing means. A mask hole 3a is formed in the screen mask 3. An air cylinder 5 is vertically supported on a support member 4 that is situated over the screen mask 3. A piston rod 5a of the air cylinder 5 slidably penetrates the support member 4. At the lower end of the piston rod 5a of the air cylinder 5, squeegee units 6 and 6' are oppositely connected to each other by means of a connecting member 31. The squeegee units 6 and 6' include squeegee holder members 7 and 7' attached to the lower end of the piston rod 5a and squeegees 9 and 9' supported by means of the squeegee holder members 7 and 7', respectively. The squeegees 9 and 9' scrape off the solder paste 8 on the screen mask 3.

Paste pressurizing slopes 7a and 7a' formed on the squeegee holder members 7 and 7' extend at an angle (acute angle) of 90° or less to the surface 3b of the screen mask 3 in the printing direction. Formed on the respective lower parts of the squeegee holder members 7 and 7' are surfaces 7b and 7b' that adjoin the paste pressurizing slopes 7a and 7a' and extend substantially parallel to the surface 3b of the screen mask 3, respectively. In the squeegees 9 and 9', scraping surfaces 9a and 9a', which are to be situated on the front side a during printing operation, are supported on the squeegee holder members 7 and 7', respectively, so as to extend at an angle of 90° or more to the surface 3b of the screen mask 3 in the printing direction. The squeegees 9 and 9' are formed of an elastic material such as urethane rubber so that at least their respective distal end portions have elasticity.

The squeegee units 6 and 6' of this embodiment (FIG. 8) are provided with paired paste pressurizing slopes 7a and 7a' that are located opposite each other and paired squeegees 9 and 9' that are located opposite each other. The respective lower ends (distal ends) of the squeegees 9 and 9' are equal in height. The opposite sides of the gap between the squeegee units 6 and 6' are closed individually by means of sidewalls 32a (only one of which is shown in FIG. 8), while the upper part of the gap is closed by means of a top wall 32b of the connecting member 31. The paste pressurizing slopes 7a and 7a', surfaces 7b and 7b' parallel to the surface 3b of the screen mask 3, squeegees 9 and 9', aforesaid opposite sidewalls 32a, and top wall 32b constitute a closed solder paste enclosure 32c.

The interior of the solder paste enclosure 32c forms an open-bottomed solder paste chamber 32. The solder paste 8 stored in the solder paste chamber 32 is surrounded by the solder paste enclosure 32c, whereby it is screened from the outside air.

A cylinder 33 is supported substantially vertically on the support member 4. The solder paste 8 is stored in the cylinder 33. A piston 34 can be pressurized downward by introducing a compressed gas 35 into the cylinder 33. When the piston 34 is pressurized by means of the compressed gas 35, the solder paste 8 in the cylinder 33 is supplied to the solder paste chamber 32. A nozzle 36 attached to the lower end of the cylinder 33 communicates with the solder paste chamber 32 by means of a passage 37 that penetrates the squeegee unit 6'. The cylinder 33, piston 34, nozzle 36, etc. constitutes a solder paste supply mechanism 38.

Pressure sensors 26 and 26' are incorporated in the squeegee holder members 7 and 7', respectively, in a manner such that their respective distal ends are exposed to the surfaces 7b and 7b' that extend along the screen mask 3. FIG. 9 shows one pressure sensor 26. When a shortage of the solder paste 8 in the solder paste chamber 32 is detected by means of the pressure sensors 26 and 26', the compressed gas 35 is supplied to the top side of the piston 34.

The support member 4 is reciprocated in the printing directions X and X' by means of a drive mechanism that resembles the drive mechanism 4a of the embodiment shown in FIG. 1.

In a solder-paste printing machine constructed in this manner, the respective lower ends of the squeegees 9 and 9' are brought into contact with the surface 3b of the screen mask 3 by means of the air cylinder 5. Then, the solder paste 8 is supplied to the solder paste chamber 32. As the squeegee units 6 and 6' move in the X-direction in this state, the solder paste 8 is pressurized by means of the paste pressurizing slope 7a. The resulting pressure causes the solder paste 8 to be pressed against the surface 3b of the screen mask 3, so that the solder paste 8 is filled into the mask hole 3a.

After the filling is finished, the solder paste 8 on the screen mask 3 is scraped off by means of the squeegee 9. When the squeegee unit 6 moves in the printing direction, the solder paste 8 on the screen mask 3 rolls, as indicated by arrow P in FIG. 8.

After the movement of the squeegee unit 6 in the X-direction or forward-stroke printing is finished, the squeegee units 6 and 6' are moved one pitch on the screen mask 3 in a direction perpendicular to the drawing plane of FIG. 8. As the squeegee units 6 and 6' move in the X'-direction, thereafter, backward-stroke printing of the solder paste 8 is carried out.

If the pressure sensors 36 and 36' detect a shortage of the solder paste 8 during a printing operation, the piston 34 is forced down by supplying the compressed gas 35 to the top side of the piston 34. By doing this, the solder paste 8 in the cylinder 33 is automatically supplied from the nozzle 36 to the solder paste chamber 32 through the passage 37 of the squeegee unit 6'.

In this embodiment, the solder paste 8 in the solder paste chamber 32 is surrounded by the solder paste enclosure 32c, whereby it is screened from the outside air. Thus, the solder paste 8 cannot easily come into contact with air during a printing operation, so that changes in the properties of the solder paste 8, attributable to oxidation or flux evaporation, can be reduced. Accordingly, an appropriate push force for the solder paste 8 can be maintained with ease.

In this embodiment, the paired paste pressurizing slopes 7a and 7a' and the paired squeegees 9 and 9' are opposed to one another in opposite directions. Thus, forward-stroke printing and backward-stroke printing can be carried out without causing the solder paste 8 to flow out of the solder paste enclosure 32c. Besides, the solder paste 8 that is pressurized by means of the paste pressurizing slopes 7a and 7a' during a printing operation can be pushed into the mask hole 3a by means of a closed curved surface that includes the paste pressurizing slopes 7a and 7a', squeegees 9 and 9', and screen mask 3. Thus, the pressure of the solder paste 8 can be effectively transmitted to the mask hole 3a, so that the efficiency of packing of the solder paste 8 can be improved.

The scraping surfaces 9a and 9a' of the squeegees 9 and 9' extend at an angle of 90° or more to the surface 3b of the screen mask 3 in the printing direction. If the solder paste 8 rolls during a printing operation, therefore, the push force never acts on the squeegees 9 and 9'. Thus, the squeegees 9 and 9' can be prevented from being lifted.

At least the near distal end portions of the squeegees 9 and 9' are elastic. If the substrate 2 or the screen mask 3 is subject to waviness, therefore, the squeegees 9 and 9' can follow it to scrape off the solder paste 8 satisfactorily.

Since the surfaces 7b and 7b' that extend substantially parallel to the surface 3b of the screen mask 3 are located adjacent the bottom side of the paste pressurizing slopes 7a and 7a', a wide high-pressure area can be provided for the solder paste 8 that is pressurized by means of the paste pressurizing slopes 7a and 7a'. Thus, the efficiency of packing of the solder paste 8 into the mask hole 3a can be improved even in a high-speed printing operation.

Since the solder-paste printing machine of this embodiment is provided with the solder paste supply mechanism 38, the solder paste 8 can be fed onto the screen mask 3 automatically and easily.

The solder paste supply mechanism 38 supplies the solder paste 8 to the solder paste chamber 32 in accordance with signals from the pressure sensors 26 and 26' that detect the pressure of the solder paste 8 in the solder paste chamber 32. If the pressure sensors 26 and 26' detect reduction of the quantity of the solder paste 8 during a printing operation, therefore, the solder paste 8 is automatically supplied by means of the solder paste supply mechanism 38.

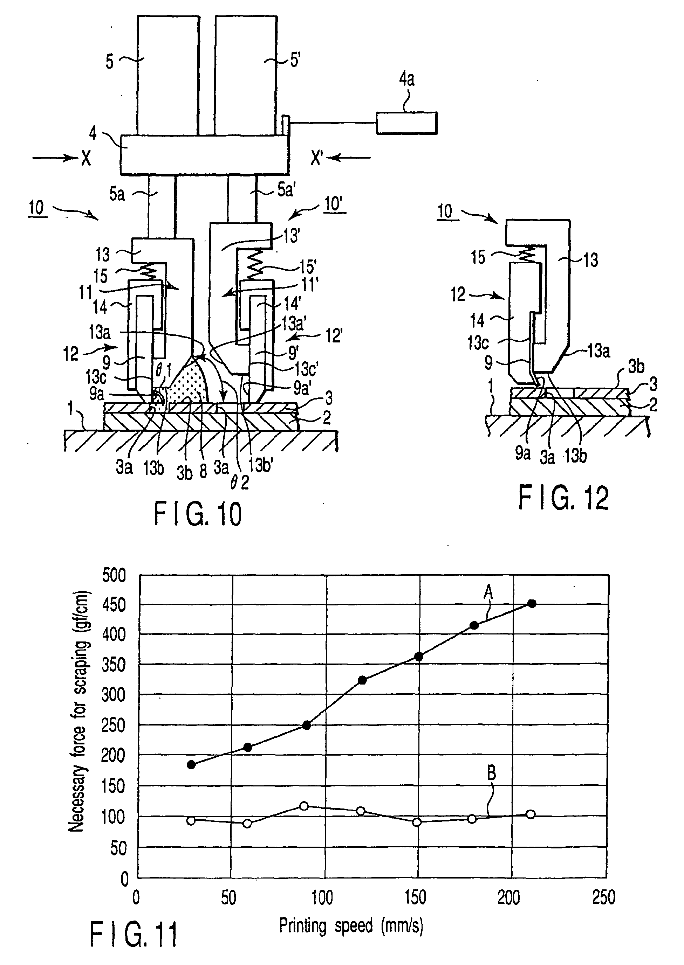

FIG. 10 shows a solder-paste printing machine of another embodiment of the present invention. Squeegee units 10 and 10' of this embodiment comprise paste pressurizing units 11 and 11' having paste pressurizing slopes 13a and 13a' and scraping units 12 and 12' having squeegees 9 and 9', respectively. The scraping units 12 and 12' serve to scrape off the solder paste 8.

The paste pressurizing units 11 and 11' and the scraping units 12 and 12' can independently move toward and away from the surface 3b of the screen mask 3 without any gaps between the units. The scraping units 12 and 12' are guided by means of guide members (not shown) so as to be movable in the vertical direction. The guide members are provided on the paste pressurizing units 11 and 11', individually. As the paste pressurizing units 11 and 11' are raised by means of air cylinders 5 and 5', the scraping units 12 and 12' also rise together. In the present embodiment, the squeegees 9 and 9' are formed of urethane rubber.

The paste pressurizing units 11 and 11' are provided with substantially U-shaped squeegee guide members 13 and 13', respectively. Formed on the lower parts of the respective front faces of the squeegee guide members 13 and 13' in the printing direction are paste pressurizing slopes 13a and 13a' that are inclined at an acute angle narrower than 90° to the surface 3b of the screen mask 3 in the printing direction. Formed on the respective lower ends of the squeegee guide members 13 and 13' are surfaces 13b and 13b' that extend substantially parallel to the surface 3b of the screen mask 3 so as to be continuous with the paste pressurizing slopes 13a and 13a'.

On the side opposite the scraping units 12 and 12', vertical surfaces 13c and 13c' are formed on the respective lower parts of the squeegee guide members 13 and 13'. The paste pressurizing units 11 and 11' are supported on a support member 4 by means of the air cylinders 5 and 5', respectively, to prevent them ascending if subjected to a reaction force during a printing operation.

The scraping units 12 and 12' are provided with squeegee holder members 14 and 14' and the squeegees 9 and 9', respectively. The scraping units 12 and 12' are slidably in contact with the vertical surfaces 13c and 13c' of the squeegee guide members 13 and 13', respectively. Scraping surfaces 9a and 9a' of the scraping units 12 and 12' extend at an angle of about 90° to the surface 3b of the screen mask 3 in the printing direction.

The scraping units 12 and 12' are urged toward the screen mask 3 by means of coil springs 15 and 15' for use as urging members. The coil springs 15 and 15' are supported by means of the squeegee guide members 13 and 13', respectively. The support member 4 that supports the squeegee units 10 and 10' is driven in the printing directions X and X' by means of a drive mechanism 4a.

As a printing table 1 that carries a substrate 2 thereon is raised, the substrate 2 is brought into contact with the lower surface of the screen mask 3. As the squeegee unit 10 is moved in the X-direction, for example, with the squeegee 9 in contact with the surface of the screen mask 3, the solder paste 8 on the screen mask 3 is pressurized by means of the paste pressurizing slope 13a.

In this embodiment, the solder paste 8 pressurized by means of the paste pressurizing slope 13a is pressed against the surface 3b of the screen mask 3 by means of a closed curved surface that includes the paste pressurizing slope 13a, surface 13b substantially parallel to the surface 3b of the screen mask 3, squeegee 9, and screen mask 3. Thus, the solder paste 8 can be effectively filled into the mask hole 3a by means of the pressure that acts on the solder paste 8 during a printing operation. The solder paste 8 on the screen mask 3 is scraped off by means of the squeegee 9.

When the squeegee 9 is stopped after the aforesaid forward-stroke printing is finished, the printing table 1 descends together with the substrate 2, whereupon the substrate 2 leaves the screen mask 3, and the solder paste 8 that is transferred to a desired position on the substrate 2 also leaves the screen mask 3. Thus, the substrate 2 is obtained with the solder paste 8 printed in the desired position.

In this embodiment, the paste scraping surface 9a of the squeegee 9 extends at an angle of about 90° to the surface 3b of the screen mask 3 in the printing direction. If the pressure of the solder paste 8 between the paste pressurizing slope 13a and the screen mask 3 during printing operation rises, therefore, the pressure never lifts up the squeegee 9. Further, the paste pressurizing unit 11 is supported on the support member 4 by means of the air cylinder 5 to prevent the unit 11 ascending due to a reaction force during a printing operation. Thus, the pressure of the solder paste 8 between the paste pressurizing unit 11 and the screen mask 3 can be prevented from changing.

Besides, the paste pressurizing unit 11 and the scraping unit 12 can move independently of the screen mask 3 in the vertical direction without leaving any gap between them. Thus, the pressure that is produced in the solder paste 8 during a printing operation cannot be released. If the printing speed and the viscosity and quantity of the solder paste 8 change, moreover, the capability of the squeegee 9 to scrape off the solder paste 8 cannot be influenced thereby. Accordingly, the capability of the squeegee 9 to scrape off the solder paste 8 need not be confirmed and the printing pressure parameter need not be set every time the printing conditions are changed. Further, the pressure of the solder paste 8 can be set and adjusted by moving the paste pressurizing slope 13a up and down without failing to keep the squeegee 9 in a predetermined position on the screen mask 3. Since the force of pressure of the air cylinder 5 cannot be transmitted directly to the squeegee 9, the force of pressure of the air cylinder 5 can be prevented from acting on the screen mask 3.

The same functions and effects of the forward-stroke printing can also be obtained for backward-stroke printing of the solder paste 8, where the squeegee unit 10' is moved in the direction indicated by X' in FIG. 10.

In this solder-paste printing machine, the surfaces 13b and 13b' that extend substantially parallel to the surface 3b of the screen mask 3 are formed on the paste pressurizing units 11 and 11', respectively. Therefore, a wide high-pressure area can be provided for the solder paste 8 that is pressurized by means of the paste pressurizing slopes 13a and 13a' during a printing operation. Thus, the efficiency of paste packing into the mask hole 3a can be improved even in a high-speed printing operation. The printing pressure can be adjusted by regulating the spaces between the surface 3a of the screen mask 3 and the surfaces 13b and 13b' that extend substantially parallel to the surface 3b of the screen mask 3.

The higher the viscosity of the solder paste 8 the narrower an angle θ2 between the paste pressurizing slopes 13a and 13a', the higher the printing speed, and the shorter the distances from the surfaces 13b and 13b' to the screen mask 3, in this solder-paste printing machine, the greater the push force for filling the solder paste 8 into the mask hole 3a can be. If the push force for the solder paste 8 is too great, some of the solder paste 8 leaks to the backside of the screen mask 3 through the mask hole 3a, thereby causing bridge connection. If the push force for the solder paste 8 is too small, a problem occurs that the solder paste 8 cannot be entirely filled into the mask hole 3a.

In this solder-paste printing machine, the scraping units 12 and 12' having the squeegees 9 and 9' are urged toward the screen mask 3 by means of the coil springs 15 and 15' during a printing operation. If the pressure of the solder paste 8 increases, therefore, the squeegees 9 and 9' cannot be pushed up, so that the squeegees 9 and 9' can be securely brought into contact with the screen mask 3.

An experiment was conducted in which the cylinder thrust (printing pressure) needed for scraping off the solder paste 8 on the screen mask 3 was measured. The following conditions were set for the solder-paste printing machine shown in FIG. 10.
Angle of inclination θ2 of paste pressurizing slope 13a: 60°
Viscosity of solder paste 8: 200 Pa·s
Distance from surface 13b substantially parallel to surface 3b of screen mask 3 to surface 3b of screen mask 3: 5 mm
Printing speed: 0 to 210 mm/s.

FIG. 11 shows the results of this experiment. In FIG. 11, line A indicates the results obtained using a squeegee unit of a conventional solder-paste printing machine shown in FIG. 24. Line B indicates the results obtained using the squeegee unit 10 of the solder-paste printing machine shown in FIG. 10. According to the conventional squeegee unit, the necessary force for scraping off the solder paste 8 is the thrust of the air cylinder 5. For squeegee unit 10 shown in FIG. 10, the necessary force for scraping off the solder paste 8 is the force of the coil spring 15.

According to the squeegee unit of the conventional solder-paste printing machine, the necessary force for scraping changed according to the printing speed, as indicated by line A. It was necessary, therefore, to set a printing pressure that never caused failed scraping. With use of the squeegee unit 10 according to the present invention, on the other hand, the solder paste 8 was able to be scraped off by means of a substantially fixed urging force without regard to the printing speed.

FIG. 12 shows a squeegee unit 10 according to another embodiment. The squeegee 9 of this present embodiment is formed of a thin metal sheet. For example, the squeegee 9 is formed of a spring steel sheet with a thickness of 0.2 mm. The squeegee 9 is fixed to the printing-direction front face of a substantially upright squeegee holder member 14.

The lower part of the squeegee 9 extends at an angle of 90° or more to the surface 3b of the screen mask 3 in the printing direction. The other squeegee 9' (not shown) is formed in the same manner as the squeegee 9. These squeegee units 10 and 10' can produce the same effects as the embodiment shown in FIG. 10.

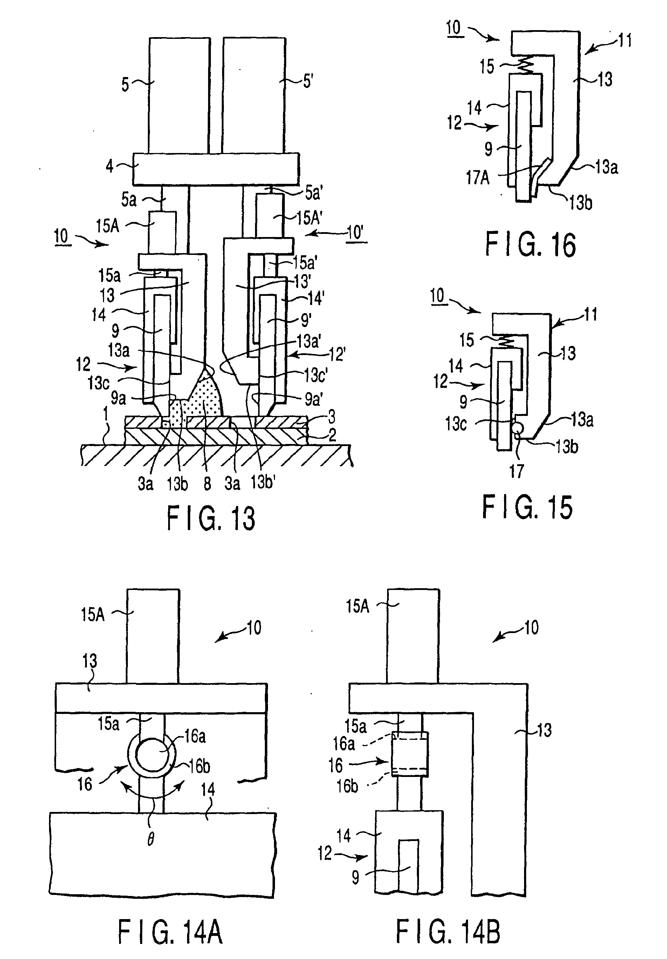

FIG. 13 shows squeegee units 10 and 10' of another embodiment of the present invention. This embodiment is provided with air cylinders 15A and 15A' as urging means for urging scraping units 12 and 12' toward the screen mask 3. These air cylinders 15A and 15A' are provided on the respective upper parts of squeegee guide members 13 and 13'.

Piston rods 15a and 15a' of the air cylinders 15A and 15A' slidably penetrate the respective upper parts of the squeegee guide members 13 and 13'. Squeegee holder members 14 and 14' are connected to the respective lower ends of the piston rods 15a and 15a'. Since this embodiment resembles the embodiment shown in FIG. 10 for other configurations, like numerals are used to designate corresponding portions of the two embodiments.

In this embodiment, the squeegee holder members 14 and 14' are urged by means of the air cylinders 15A and 15A', so that the push force of the squeegees 9 and 9' against the screen mask 3 can be kept constant without regard to the height of the squeegee guide members 13 and 13'.

FIGS. 14A and 14B show a squeegee unit 10 of another embodiment of the present invention. In this embodiment, a piston rod 15a of an air cylinder 15A and a squeegee holder member 14 are coupled by means of a floating joint 16. The floating joint 16 allows a squeegee guide member 13 and the squeegee holder member 14 to swing from side to side (in the direction indicated by arrow Q in FIG. 14A) as viewed from the front side in the printing direction.

The floating joint 16 includes a columnar portion 16a, which is provided on the lower end of the piston rod 15a and extends in the longitudinal direction, and a grip portion 16b rockable in the aforesaid swinging direction with respect to the columnar portion 16a. The grip portion 16b protrudes from the upper surface of the squeegee holder member 14. A squeegee holder member 14' and a squeegee 9' (neither of which is shown) on the other side are configured to be swingable from side to side in the same manner as aforesaid.

In this embodiment, a squeegee 9 is connected to the squeegee guide member 13 by means of the floating joint 16. If the substrate 2 and the screen mask 3 are inclined to the left or right as viewed from the front side in the printing direction, therefore, the solder paste 8 can be scraped off without hindrance by means of the squeegee 9.

FIG. 15 shows a squeegee unit 10 of another embodiment of the present invention. In this embodiment, a seal member 17 of rubber, foamed plastic, or the like is provided between a paste pressurizing unit 11 and a scraping unit 12. The space between the paste pressurizing unit 11 and the scraping unit 12 is sealed by means of the seal member 17. A similar seal member 17' is also provided between a paste pressurizing unit 11' and a scraping unit 12' (neither of which is shown) on the other side.

According to the squeegee unit 10 provided with the seal member 17, there is no possibility of the solder paste 8 in a pressurized state leaking out through a gap between the paste pressurizing unit 11 and scraping unit 12. Accordingly, the pressure of the solder paste 8 can be securely prevented from lowering during a printing operation, and the solder paste 8 can be effectively utilized without waste.

FIG. 16 shows a squeegee unit 10 of another embodiment of the present invention. In this embodiment, a seal member 17A formed of a plate spring with a thickness of about 0.1 mm is provided between paste pressurizing unit 11 and scraping unit 12. The space between the paste pressurizing unit 11 and the scraping unit 12 is sealed by means of the seal member 17A. A similar seal member 17A' is also provided between a paste pressurizing unit 11' and a scraping unit 12' (neither of which is shown) on the other side.

The squeegee unit 10 provided with this seal member 17A can produce the same effects as the embodiment shown in FIG. 15. If the seal member 17A used is formed of a plate spring, in particular, the area of contact of the seal member 17A on the scraping unit 12 is reduced, so that the vertical movement of the scraping unit 12 is smoothened.

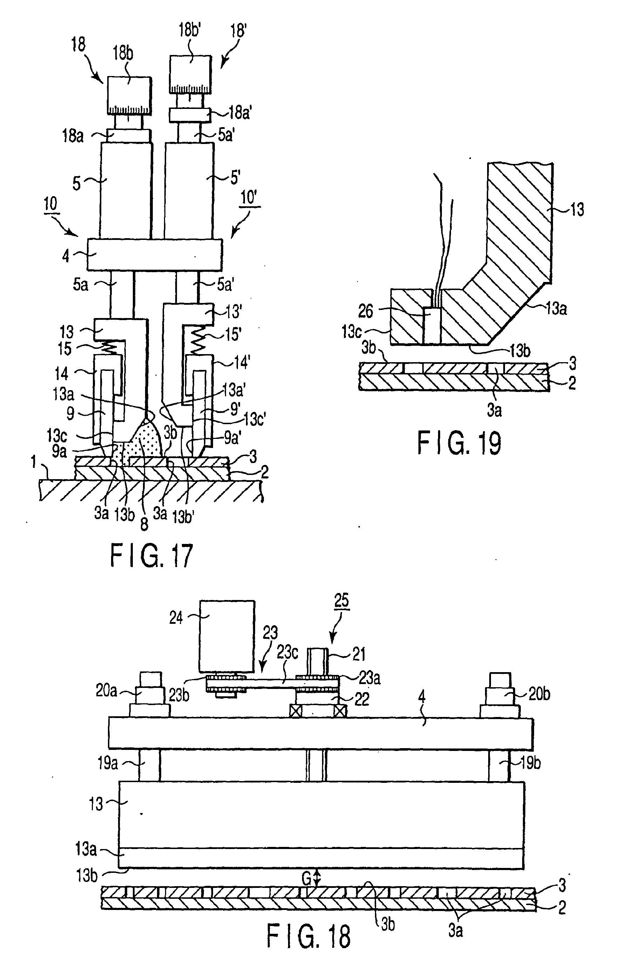

FIG. 17 shows a solder-paste printing machine of another embodiment of the present invention. In this printing machine, the respective upper end portions of piston rods 5a and 5a' of air cylinders 5 and 5' project upward from the respective upper ends of their corresponding air cylinders 5 and 5'. Space setting mechanisms 18 and 18' are attached to the respective upper end portions of these piston rods 5a and 5a', respectively.

The space setting mechanisms 18 and 18' are provided, respectively, with movable stopper members 18a and 18a' that are slidably fitted around the respective upper end portions of the piston rods 5a and 5a'. The respective heights of the movable stopper members 18a and 18a' can be adjusted by turning operating members 18b and 18b', respectively. The respective down-side stop positions of the piston rods 5a and 5a' can be adjusted in accordance with the respective heights of the movable stopper members 18a and 18a'. Accordingly, the distances from lower surfaces 13b and 13b' of squeegee guide members 13 and 13' to the screen mask 3 can be easily adjusted. Thus, the printing pressure can be adjusted with ease.

The space setting mechanisms 18 and 18' may be constructed so that thread portions are provided individually around the respective upper end portions of the piston rods 5a and 5a', and nuts that serve as movable stopper members are screwed individually on the thread portions, the respective heights of the nuts being changeable.

FIG. 18 shows a solder-paste printing machine of another embodiment of the present invention. In this embodiment, guide rods 19a and 19b are provided upright on the opposite end portions of the upper surface of a squeegee guide member 13. Guide bushes 20a and 20b are fixed to the upper part of a support member 4. The guide rods 19a and 19b penetrate the guide bushes 20a and 20b, respectively, so as to be slidable in the vertical direction.

A ball screw 21 is set upright on the center of the upper surface of the squeegee guide member 13. The ball screw 21 is screwed in a nut member 22. The nut member 22 is rotatably supported on the upper surface of the support member 4. The ball screw 21 vertically penetrates the support member 4. A pulley 23a is provided around the nut member 22. A belt 23c is passed around and between paired pulleys 23a and 23b. These pulleys 23a and 23b and the belt 23c constitute a turning force transmission mechanism 23.

The pulley 23b can be rotated forwardly and reversely by means of a motor 24. The ball screw 21, nut member 22, turning force transmission mechanism 23, motor 24, etc. constitute an automatic squeegee unit lift mechanism 25. A squeegee guide member 13' (not shown) on the other side is also provided with an automatic squeegee unit lift mechanism 25' (not shown) of the same construction.

These automatic squeegee unit lift mechanisms 25 and 25' may be also composed individually of racks on the squeegee guide members 13 and 13', pinions in mesh with them, and motors for rotating the pinion.

According to the solder-paste printing machine provided with the automatic squeegee unit lift mechanisms 25 and 25' constructed in this manner, a gap G between the surface 3b of the screen mask 3 and each of surfaces 13b and 13b' that are substantially parallel to the surface 3b of the screen mask 3 can be adjusted automatically.

FIG. 19 shows a part of a solder-paste printing machine of another embodiment of the present invention. In this embodiment, a pressure sensor 26 is attached to the lower part of a squeegee guide member 13. The lower end portion of the pressure sensor 26 is exposed to a surface 13b that extends substantially parallel to the surface 3b of the screen mask 3. The pressure sensor 26 can be used to measure the pressure of the solder paste 8 that exists between the aforesaid surface 13b of the squeegee guide member 13 and the surface 3b of the screen mask 3, that is, printing pressure.

For example, the distance G between the surface 13b of the squeegee guide member 13 and the surface 3b of the screen mask 3 can be controlled by applying a pressure value delivered from the pressure sensor 26 to a controller for controlling the motor 24 of the automatic squeegee unit lift mechanism 25 shown in FIG. 18. Thus, printing can be carried out under a constant printing pressure. If the printing speed, viscosity of the solder paste, quantity of the solder paste, etc. change, therefore, stable solder-paste printing can be ensured, since the printing pressure can be kept constant.

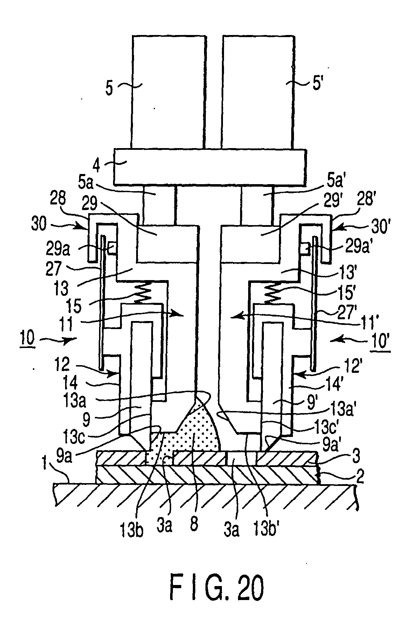

FIG. 20 shows a solder-paste printing machine of another embodiment of the present invention. In this embodiment, support members 27 and 27', each formed of a metal sheet with a width of 1 cm and thickness of 0.3 mm, for example, are fixed to squeegee holder members 14 and 14', respectively. These support members 27 and 27' extend over the squeegee holder members 14 and 14'. Receiving members 28 and 28' are provided on the respective upper parts of squeegee guide members 13 and 13', respectively. The receiving members 28 and 28' are formed in positions such that they can support the respective back surfaces of their corresponding support members 27 and 27'.

Air cylinders 29 and 29' are provided on the respective upper parts of the squeegee guide members 13 and 13', respectively. The respective distal ends of piston rods 29a and 29a' of the air cylinders 29 and 29' are opposed to the receiving members 28 and 28', respectively. The receiving members 28 and 28' and the air cylinders 29 and 29' constitute squeegee descent preventing mechanisms 30 and 30' for preventing scraping units 12 and 12' from descending. For other configurations, this embodiment resembles the embodiment shown in FIG. 10.

According to the above embodiment provided with the squeegee descent preventing mechanisms 30 and 30', the respective upper parts of the support members 27 and 27' can be held between the piston rods 29a and 29a' and the receiving members 28 and 28' by actuating the air cylinders 29 and 29' before separating the substrate 2 from the screen mask 3 after the printing is finished. Thus, the scraping units 12 and 12' can be prevented from pushing the screen mask 3 as the substrate 2 is separated from the screen mask 3.

If a part of the screen mask 3 is pushed down by means of the scraping units 12 and 12', that part of the screen mask 3 projects downward, so that the substrate 2 cannot separate uniformly from the screen mask 3. According to the aforesaid embodiment that is provided with the squeegee descent preventing mechanisms 30 and 30', however, this problem can be avoided.

In the case where both the paired squeegee units 10 and 10' rest on the screen mask 3 as they are used, a squeegee 9' that is not used for printing can be pre-locked by means of the squeegee descent preventing mechanism 30', for example. In this case, working squeegee 9 need not be raised immediately after a printing operation, so that the solder paste 8 adhering to the scraping unit 12 can be prevented from scattering onto the screen mask 3 as the unit 12 ascends. Besides, the unit 12 need not waiting before the solder paste 8 finishes falling from the unit 12 onto the screen mask 3.

Since the solder paste 8 is surrounded by the pair of squeegee units 10 and 10', moreover, the area of contact of the solder paste 8 with the atmosphere can be reduced. Accordingly, the solder paste 8 on the screen mask 3 can be prevented from drying.

The scraping units 12 and 12' can be pressed against the screen mask 3 by utilizing the dead weight of the scraping units 12 and 12' instead of using coil springs 15 and 15'.

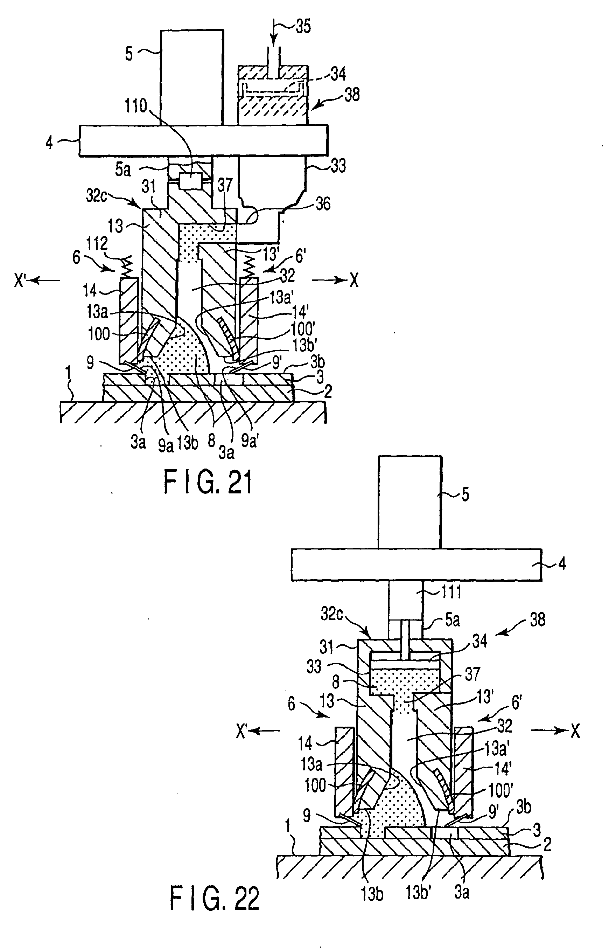

FIG. 21 shows a solder-paste printing machine of another embodiment of the present invention. In connection with this embodiment, common numerals refer to common portions that are shared with the embodiment shown in FIG. 8. Squeegee units 6 and 6' of the embodiment shown in FIG. 21 are connected to each other by means of a connecting member 31. The squeegee units 6 and 6' comprise squeegee guide members 13 and 13', which have paste pressurizing slopes 13a and 13a', and slide holder members 14 and 14', which have squeegees 9 and 9', respectively.

The squeegee guide members 13 and 13' and the slide holder members 14 and 14' can independently move toward and away from the surface 3b of the screen mask 3. Elastic seal members 100 and 100' are provided between the squeegee guide members 13 and 13' and the slide holder members 14 and 14', respectively. The seal members 100 and 100' are supported by means of the squeegee guide members 13 and 13', respectively. The respective distal ends of the seal members 100 and 100' are pressed against the respective side faces of the slide holder members 14 and 14', respectively. The slide holder members 14 and 14' are supported for vertical movement by means of the squeegee guide members 13 and 13' that have the paste pressurizing slopes 13a and 13a', respectively.

Scraping surfaces 9a and 9a' of the squeegees 9 and 9' extend individually at an angle of 90° or more to the surface 3b of the screen mask 3 in the printing direction. The squeegees 9 and 9' are formed of urethane rubber, for example.

The paired squeegee guide members 13 and 13', which have the paste pressurizing slopes 13a and 13a', respectively, are arranged in opposite directions. These squeegee guide members 13 and 13' are formed having surfaces 13b and 13b', respectively, which extend substantially parallel to the surface 3b of the screen mask 3. The surfaces 13b and 13b', paste pressurizing slopes 13a and 13a', opposite sidewalls at the transversely opposite ends of the squeegee guide members 13 and 13', connecting member 31, etc. constitute a solder paste enclosure 32c that is cut off from the outside air. The interior of the solder paste enclosure 32c forms an open-bottomed solder paste chamber 32.

The solder paste chamber 32 is supplied with the solder paste 8 from a nozzle 36 of a solder paste supply mechanism 38, which is constructed in the same manner as the one according to the embodiment shown in FIG. 8, through a passage 37. A pressure sensor 110 formed of a load cell is incorporated in the middle of a piston rod 5a of an air cylinder 5. The pressure sensor 110 detects pressure that is produced as the solder paste 8 rolls and acts on the squeegee guide members 13 and 13'. If the quantity of the solder paste 8 in the solder paste chamber 32 lessens, the pressure of the solder paste 8 during a printing operation is reduced. When the reduction of the pressure is detected by means of the pressure sensor 110, the compressed gas 35 is supplied to the space over a piston 34 in a cylinder 33.

The squeegee guide members 13 and 13', which have the paste pressurizing slopes 13a and 13a', respectively, are supported on a support member 4 by means of the air cylinder 5 lest they be raised due to the reaction force that is produced during a printing operation. The slide holder members 14 and 14', which have the squeegees 9 and 9', respectively, are urged toward the screen mask 3 by means of urging members 112 such as springs, individually.

In this embodiment, the squeegee guide members 13 and 13' having the paste pressurizing slopes 13 and 13a' and the slide holder members 14 and 14' can move in the vertical direction without any gaps left between them. The scraping surfaces 9a and 9a' extend at an angle of 90° or more to the surface 3b of the screen mask 3 in the printing direction. The printing pressure for the solder paste 8 can be adjusted by moving the paste pressurizing slopes 13 and 13a' up and down with the squeegees 9 and 9' kept in predetermined positions on the screen mask 3.

FIGS. 22 and 23 show a solder-paste printing machine of another embodiment of the present invention. In connection with this embodiment, like numerals refer to portions corresponding to the embodiment shown in FIG. 21.

In the embodiment shown in FIGS. 22 and 23, a cylinder 33 is formed in a connecting member 31 that connects the respective upper ends of squeegee guide members 13 and 13' that have paste pressurizing slopes 13a and 13a', respectively. A piston 34 is located in the cylinder 33. The piston 34 can pressurize the two air cylinders 111 that are supported by means of a support member 4. A solder paste enclosure 32c is composed of a pair of squeegee guide members 13 and 13', a pair of sidewalls 32a, a top wall 32b (shown in FIG. 23), etc. A solder paste chamber 32 that is shield from the outside air is formed in the solder paste enclosure 32c.

The solder paste 8 is stored in the cylinder 33. As the piston 34 is pressurized by means of the air cylinders 111, the solder paste 8 in the cylinder 33 is fed into the solder paste enclosure 32c or the solder paste chamber 32 through a passage 37. In the embodiment shown in FIG. 22, the principal part of a solder paste supply mechanism 38 is incorporated in the connecting member 31. Accordingly, the external appearance can be simplified. This embodiment, in particular, can be readily applied to the case where squeegee units 6 and 6' are long in their width direction. Since this embodiment resembles the embodiment shown in FIG. 21 in other configurations, it can produce the same effects as the embodiment shown in FIG. 21.

In each of the embodiments shown in FIGS. 21 and 22, the pressure sensor 26 shown in FIG. 9 may be provided in a manner such that the distal end of the sensor 26 is exposed in each of surfaces 13b and 13b' that extend substantially parallel to the screen mask 3.

### Industrial Applicability

Squeegee units of the present invention can be utilized in the field of printing machines using a screen mask, including solder-paste printing machines.

## Claims

1. A squeegee unit **characterized by** comprising:
a member (7, 13) having a paste pressurizing slope (7a, 13a) for pressurizing solder paste (8) on a screen mask (3) during printing operation, thereby filling said solder paste (8) into a mask hole (3a); and
a squeegee (9) movable in a printing direction along said screen mask (3), the squeegee (9) having a paste scraping surface (9a) for scraping off said solder paste (8) on said screen mask (3),
said paste scraping surface (9a) extending at an angle (θ1) of 90° or more to a surface (3b) of the screen mask (3) in the printing direction.

2. A squeegee unit according to claim 1,
**characterized in that** said paste pressurizing slope (7a, 13a), squeegee (9), and surface (3b) of the screen mask (3) forms at least a part of a solder paste enclosure (32c).

3. A squeegee unit according to claim 1,
**characterized in that** at least a distal end portion of said squeegee (9) in contact with said screen mask (3) is composed of an elastic material.

4. A squeegee unit according to claim 1,
**characterized in that** said paste pressurizing slope (7a, 13a) projects from the paste scraping surface (9a) of said squeegee (9) in said printing direction.

5. A squeegee unit according to claim 1,
**characterized in that** said member (7, 13) having said paste pressurizing slope (7a, 13a) is formed having a surface (7b, 13b) adjoining said paste pressurizing slope (7a, 13a) and extending along the surface (3b) of said screen mask (3).

6. A squeegee unit according to claim 1, which further comprises a paste pressurizing unit (11) having said paste pressurizing slope (7a, 13a) and a scraping unit (12) having said squeegee (9), the paste pressurizing unit (11) and the scraping unit (12) being independently movable toward and away from the surface (3b) of said screen mask (3) without a gap.

7. A squeegee unit according to claim 6, which further comprises a squeegee descent preventing mechanism (30) capable of preventing said scraping unit (12) from descending with respect to said paste pressurizing unit (11).

8. A solder-paste printing machine **characterized by** comprising:
a screen mask (3) having a mask hole (3a);
a member (7, 13) having a paste pressurizing slope (7a, 13a) extending at an angle (θ2) of 90° or less to a surface (3b) of the screen mask (3) in a printing direction;
a squeegee (9) movable in a printing direction along said screen mask (3), the squeegee (9) having a paste scraping surface (9a) for scraping off said solder paste (8) on said screen mask (3); and
a drive mechanism (4a) for moving the member (7, 13) having said paste pressurizing slope (7a, 13a) and said squeegee (9) in the printing direction,
said paste scraping surface (9a) extending at an angle (θ1) of 90° or more to the surface (3b) of the screen mask (3) in the printing direction.

9. A solder-paste printing machine according to claim 8, which further comprises a paste pressurizing unit (11) having said paste pressurizing slope (7a, 13a) and a scraping unit (12) having said squeegee (9), the paste pressurizing unit (11) and the scraping unit (12) being independently movable toward and away from the surface (3b) of said screen mask (3) without a gap, and a support member (4) for restraining the paste pressurizing unit (11) having said paste pressurizing slope (7a, 13a) from being raised by means of reaction force during a printing operation.

10. A solder-paste printing machine according to claim 9, which further comprises an urging member (15) for bringing the scraping unit (12) having said squeegee (9) into contact with the surface (3b) of said screen mask (3) at least during a printing operation.

11. A solder-paste printing machine according to claim 9, which further comprises a seal member (17, 17a) provided between said paste pressurizing unit (11) and the scraping unit (12).

12. A solder-paste printing machine according to claim 9, **characterized in that** said paste pressurizing unit (11) comprises a space setting mechanism (18) for adjusting the distance from a surface (7b, 13b) substantially parallel to the surface (3b) of said screen mask (3) to the screen mask (3).

13. A solder-paste printing machine according to claim 9, **characterized in that** said paste pressurizing unit (11) comprises an automatic squeegee unit lift mechanism (25) for raising and lowering said support member (4).

14. A solder-paste printing machine according to claim 9, **characterized in that** said paste pressurizing unit (11) comprises a pressure sensor (26) for detecting the pressure of said solder paste (8) on said screen mask (3).

15. A squeegee unit **characterized by** comprising:
a first paste pressurizing slope (7a, 13a) for pressurizing solder paste (8) on a screen mask (3), thereby filling said solder paste (8) into a mask hole (3a);
a second paste pressurizing slope (7a', 13a') reversely opposed to said first paste pressurizing slope (7a, 13a) and capable of pressurizing the solder paste (8) on the screen mask (3), thereby filling said solder paste (8) into the mask hole (3a);
a first squeegee (9) movable in a printing direction along said screen mask (3), the first squeegee (9) having a paste scraping surface (9a) for scraping off said solder paste (8) on said screen mask (3);
a second squeegee (9') reversely opposed to said first squeegee (9) and movable in the printing direction along said screen mask (3), the second squeegee (9') having a paste scraping surface (9a') for scraping off said solder paste (8) on said screen mask (3); and
a solder paste enclosure (32c) forming a solder paste chamber (32) enclosing the solder paste (8) between the first and second squeegees (9, 9').

16. A squeegee unit according to claim 15,
**characterized in that** said paste scraping surface (9a) of said first squeegee (9) extends at an angle (θ1) of 90° or more to the surface (3b) of the screen mask (3) in the printing direction, and said paste scraping surface (9a') of said second squeegee (9') also extends at the angle (θ1) of 90° or more to the surface (3b) of the screen mask (3) in the printing direction.

17. A squeegee unit according to claim 15,
**characterized in that** said solder paste chamber (32) is connected with a solder paste supply mechanism (38) for supplying said solder paste (8).

18. A squeegee unit according to claim 17,
**characterized in that** at least a part of said solder paste supply mechanism (38) is incorporated in a member (7, 13) having said paste pressurizing slope (7a, 13a).

19. A squeegee unit according to claim 17, which further comprises a pressure sensor (26) for detecting the pressure of the solder paste (8) in said solder paste chamber (32) so that said solder paste supply mechanism (38) can supply the solder paste (8) to said solder paste chamber (32) in accordance with a signal from said pressure sensor (26).

20. A squeegee unit according to claim 15, which further comprises members (13, 13') formed having said first and second paste pressurizing slopes (13a, 13a'), individually, and first and second slide holder members (14, 14') provided for vertical movement without leaving gaps with respect to the members (13, 13'), the slide holder members (14, 14') being provided with the first and second squeegees (9, 9'), respectively.
